# EUROPEAN PATENT SPECIFICATION

(11) **EP 2 366 230 B1**
(45) Date of publication and mention of the grant of the patent: **28.11.2012**
(21) Application number: 09768404.7
(22) Date of filing: 16.12.2009
(51) Int. Cl.: H04L 1/00

(54) **METHOD AND DEVICE FOR TRANSMITTING AND RECEIVING DIGITAL INFORMATION BY USE OF A FEC FRAME COMPRISING AT LEAST TWO FEC FRAME HEADERS**
VERFAHREN UND EINRICHTUNG ZUM SENDEN UND EMPFANGEN VON DIGITALEN INFORMATIONEN DURCH VERWENDUNG EINES FEC-RAHMENS MIT MINDESTENS ZWEI FEC-RAHMENKOPFTEILEN
PROCÉDÉ ET DISPOSITIF PERMETTANT DE TRANSMETTRE ET DE RECEVOIR DES INFORMATIONS NUMÉRIQUES EN UTILISANT UNE TRAME FEC COMPRENANT AU MOINS DEUX EN-TÊTES DE TRAME FEC

(30) Priority: 16.12.2008 EP 08305951
(43) Date of publication of application: 21.09.2011
(73) Proprietor: Thomson Licensing, 92100 Boulogne-Billancourt (FR)
(72) Inventor: ZHOU, Wei, F-92648 Boulogne Cedex (FR)
(74) Representative: Esselin, Sophie
(86) International application number: PCT/EP2009/067285
(87) International publication number: WO 2010/069996

(56) References cited:
- EP-A2- 1 912 357
- WO-A1-01/74012
- WO-A1-2008/013528
- S. Aikawa, Y.Motoyama, M. Umehira: "Error correction and error detection techniques for wireless ATM systems" In: 1997, ACM, 2 PENN PLAZA, SUITE 701 - NEW YORK USA , Kanagawa 239, Japan , XP040093222 , pages 285-290 see page 285, left-hand column, last two paragraphs; see page 286, chapter "3. A new FEC scheme for wireless ATM"; see figure 2; see page 287, right-hand column, last paragraph; see conclusion
- GUY COTÉ MICHAEL GALLANT U BRIT COLUMBIA ET AL: "A Correct Place for a Channel Coder to Support Unequal Error Protection for H.263++ and H.26L" 14 October 1999 (1999-10-14), JOINT VIDEO TEAM (JVT) OF ISO/IEC MPEG & ITU-T VCEG(ISO/IEC JTC1/SC29/WG11 AND ITU-T SG16 Q6), XX, XX , XP030002993 see SUMMARY; see chapter "General remarks about channel coders and our environment", first paragraph; see second page, chapter "Current situation", second paragraph; see page 3, second paragraph.

## Description

### FIELD OF THE INVENTION

The present invention relates in general to communication system, and more particularly, to a method and apparatus for transmitting and receiving digital information in the communication system.

### BACKGROUND OF THE INVENTION

Digital information with signalling is transported in a digital communication system. The signalling is used for helping the receiver to receive and detect data carried in the digital information. For example, DVB-T (Digital Video Broadcast-Terrestrial), DTMB (Digital Terrestrial Multimedia Broadcast, Chinese Terrestrial standard) and the latest DVB-T2 standard all define a format of the digital information with signalling.

In addition, Digital Video Broadcasting-Cable (DVB-C) which is a first generation cable transmission system (e.g., see EN 300 429 V.1.2.1 (1998-04) Digital Video Broadcasting (DVB); Framing structure, channel coding and modulation for cable systems), is currently being studied to migrate to a second generation cable system, DVB-C2, and being studied for protecting the signalling information.

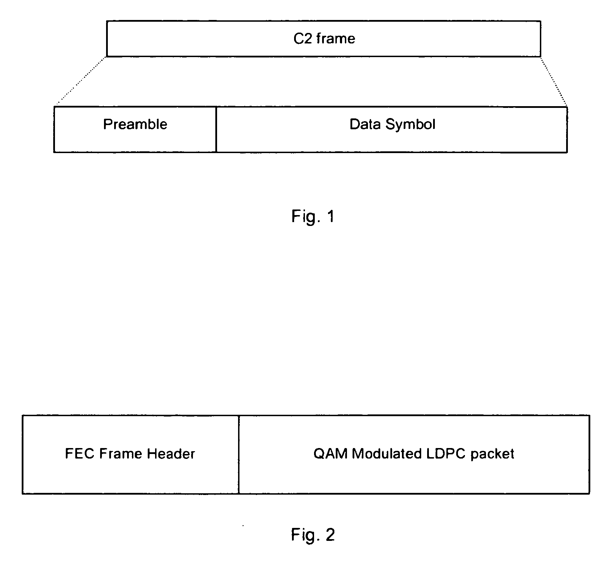

Fig.1 is a schematic diagram showing a DVB-C2 frame structure used in a DVB-C2 system. As shown in Fig.1, the DVB-C2 frame includes a preamble and a data symbol. The preamble can help a receiver of the system to detect the C2 frame and get the synchronization information. The preamble includes L1 (Layer 1) signalling information. In data symbol, the data streams will be included and transmitted. In C2 frame, parameters for FEC (Forward Error Correction) frame modulation and code rate will be included in Data symbols.

After interleaver processing for FEC frames processing including time domain and frequency domain process, an OFDM frame (not shown in Fig.1) is formed, and multiple OFDM frames form a DVB-C2 frame. A FEC frame builder is used to form the FEC frames, and there are two streams which will be input to the FEC frame builder to form the FEC frame. One stream is signalling information, another stream is data.

The L1 signalling information includes the modulation parameter, FEC parameter and PLP (Physical Layer Pipe) identifier which indicate that which PLP the following LDPC (Low Density Parity Codes) packet belong to. Here, LDPC is used to form the FEC frame as an example. First, L1 signalling information will be encoded by one Frame header encoder. And then, the output will be modulated. Finally, the modulated symbol will input into FEC frame building device.

The data is encoded by the LDPC encoder firstly. And then, the bits streams are interleaved by one bit interleaver and modulated by QAM modulator in turn. Finally, the QAM symbol is input into FEC frame builder.

Figure 2 is a schematic structure of a FEC frame formed in a FEC frame builder. As shown in Figure 2, a FEC frame is build in FEC frame builder includes a FEC header and QAM modulated LDPC packet.

However, the overhead of FEC header will occupy too much transmission resource, so it is needed to improve the encoding scheme of the FEC frame.

### SUMMARY OF THE INVENTION

According to one aspect of the invention, provide a method used in a transmitter of a communication system, comprising:
building a first Forward Error Correction, FEC, frame comprising at least two FEC frame headers and a data packet, wherein one of the at least two FEC frame headers is a signalling information of the first FEC frame and other of the at least two FEC frame headers is respectively a signalling information of at least one consecutive second FEC frame after the first FEC frame; and building the at least one consecutive second FEC frame comprising the data packet of the at least one consecutive second FEC frame and omitting its headers if the at least two FEC frame headers are the same.

The invention also concerns a method used in a receiver of a communication system, for decoding an encoded frame, comprising: receiving a first FEC frame including at least two FEC frame headers and data packet, wherein one of the at least two FEC frame headers is a signalling information of the first FEC frame and other of the at least two FEC frame headers is respectively a signalling information of at least one consecutive second FEC frame after the first FEC frame; comparing the at least two FEC frame headers, and if the at least two FEC frame headers are the same, the at least one consecutive second FEC frame only includes the data packet thereof without a FEC frame header.

The invention also concerns a transmitter and a receiver for implementing the above corresponding methods.

### BRIEF DESCRIPTION OF DRAWINGS

Fig.1 is a schematic diagram showing an OFDM frame structure used in a DVB-C2 system;
Figure 2 is a schematic structure of a FEC frame formed in a FEC frame builder;
Figure 3 is an illustrative block diagram showing a communication system comprising a transmitter and a receiver according to an embodiment of the invention; and
Fig. 4 is a schematic diagram showing an encoding scheme for the FEC frame according to the embodiment of the invention.

### DETAIL DESCRIPTION OF PREFERRED EMBODIMENTS

Other than the inventive concept, the elements shown in the figures are well known and will not be described in detail. For example, other than the inventive concept, familiarity with Discrete Multitone (DMT) transmission (also referred to as Orthogonal Frequency Division Multiplexing (OFDM) or Coded Orthogonal Frequency Division Multiplexing (COFDM)) is assumed and not described herein. Also, familiarity with television broadcasting, receivers is assumed and is not described in detail herein. For example, other than the inventive concept, familiarity with current and proposed recommendations for TV standards such as NTSC (National Television Systems Committee), PAL (Phase Alternation Lines), SECAM (Sequential Couleur Avec Memoire), ATSC (Advanced Television Systems Committee) (ATSC), Digital Video Broadcasting (DVB), Digital Video Broadcasting-Terrestrial (DVB-T) (e.g., see ETSI EN 300 744 V1.4.1 (2001-01)); Framing structure, channel coding and modulation for digital terrestrial television; Digital Video Broadcasting-Cable (DVB-C) (e.g., see EN 300 429 V.1.2.1 (1998-04)), Digital Video Broadcasting (DVB); Framing structure, channel coding and modulation for cable systems); Digital Video Broadcast-satellite (DVB-S2) system (e.g., see European Telecommunications Standards Institute (ETSI) Draft EN 302307, v.1.1.1, June 2004); and the Chinese Digital Television System (GB) 20600-2006 (Digital Multimedia Broadcasting - Terrestrial / Handheld (DMB-T/H)) is assumed. Further, other than the inventive concept, familiarity with processing signals, such as forming channel state information, is assumed and not described herein. Similarly, other than the inventive concept, formatting and encoding methods (such as Moving Picture Expert Group (MPEG)-2 Systems Standard (ISO/IEC 13818-1)) for generating transport bit streams are well-known and not described herein. It should also be noted that the inventive concept may be implemented using conventional programming techniques, which, as such, will not be described herein. In this regard, the embodiments described herein may be implemented in the analog or digital domains.

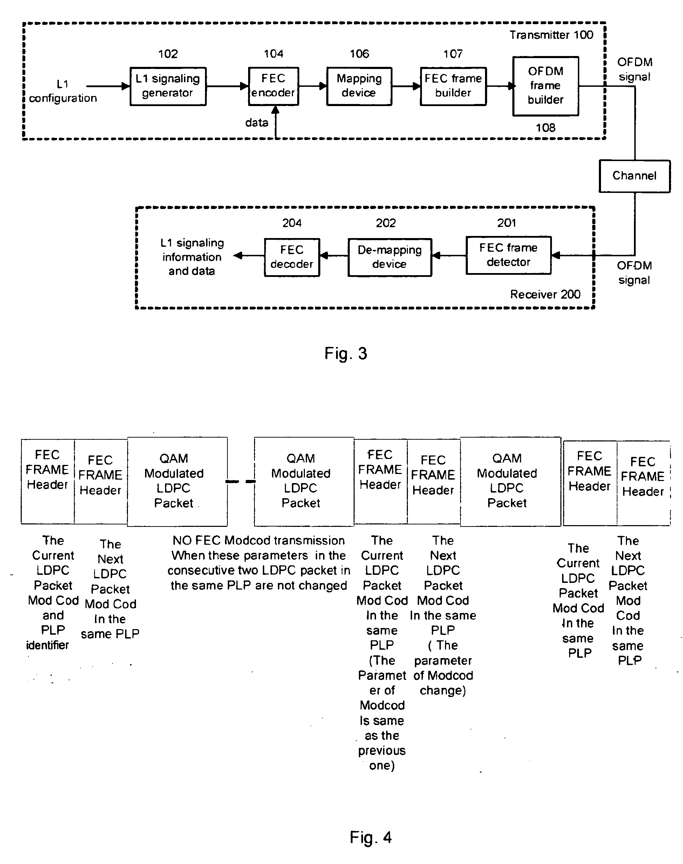

Figure 3 is an illustrative block diagram showing a communication system comprising a transmitter and a receiver according to an embodiment of the invention.

Referring now to Fig. 3, an illustrative block diagram of a communication system according to the embodiment is shown comprising a transmitter 100 and a receiver 200. Only those portions relevant to explanation of the embodiment of the invention are shown in transmitter 100 and receiver 200. In the communication system, the transmitter 100 transmits (or broadcasts) a OFDM signal with video and/or audio information formed by FEC frames to the receiver 200 through communication channel, as shown in Fig.3.

Transmitter 100 comprises L1 signalling generator 102, FEC encoder 104, mapping device 106, FEC frame builder 107 and OFDM frame builder 108. Alternatively, transmitter 100 is a processor-based system and includes one or more processors and associated memory. In this context, computer programs, or software, are stored in the memory for execution by the processor, e.g., to implement FEC encoder 104. The processor is representative of one or more stored-program control processors and these do not have to be dedicated to the signalling information protection function, e.g., the processor may also control other functions of transmitter 100. The memory is representative of any storage device, e.g., random-access memory (RAM), read-only memory (ROM), etc.; may be internal and/or external to transmitter 100; and is volatile and/or non-volatile as necessary.

In transmitter 100, L1 signalling generator 102 is adapted to providing L1 signalling parameter, e.g., FFT size, guard interval pilot pattern choosing, coding rate and modulation scheme, for each transmitted C2 frame to the receiver 200 according to the DVB transmission standard. The L1 signalling parameters can change from frame to frame. In addition, how the signalling parameters are selected is irrelevant to the inventive concept and performed in accordance with DVB. According to the embodiment, the L1 signalling generator 102 also provides signalling parameters such as code rate and modulation, for each FEC block of data symbols in the frame. The signalling parameters can also change from FEC frame to FEC frame, that is, Variable coding and modulation (VCM).

FEC encoder 104 is adapted to encode the signalling parameters and data information for each FEC frame to form an encoded frame, e.g., by using concatenation codes to protect L1 signalling information and data. Alternatively, the signalling parameters and data information may use separate FEC encoders or a single FEC encoder.

According to the embodiment as shown in Fig. 3, transmitter 100 modulates the FEC encoded signalling and data by mapping device 106, for example, to form QAM symbols, and the FEC frame builder 107 builds a FEC frame as shown in Fig. 4 which is a schematic diagram showing an encoding scheme for the FEC frame according to the embodiment of the invention.

As shown in Figure 4, there are two FEC frame headers before FEC packet (here, the FEC packet is QAM modulation LDPC packet) of a first FEC frame according to the embodiment. If consecutive FEC frames after the first FEC frame are in the same PLP (physical layer pipe) as the first FEC frame, and the modulation and code rate parameter in the consecutive QAM modulation LDPC packets in the same PLP are not changed, the two FEC frame headers will be the same, while the same the FEC frame header in consecutive FEC frames after the first FEC frame will be deleted and not built in the corresponding FEC frame and not transmitted to the receiver 200. In the embodiment, the FEC frame header is formed by PLP, modulation and code rate. However, those skilled in the art will recognize that the invention described herein is not limited to the embodiment, but can instead be formed by other parameters. Alternatively, the consecutive FEC frames can be one FEC frame after the first FEC frame, or more than one consecutive FEC frames.

When the modulation and code rate parameter in the consecutive two QAM modulation LDPC packets in the same PLP are changed, the first FEC frame header and the next FEC frame header both will be built in the FEC frame and transmitted which is shown in figure 4. For example, the first FEC header carries FEC packet parameter of the first FEC frame, which include the LDPC code rate, modulation parameter and PLP identifier, and the second FEC frame header carries the next FEC packer parameter.

According to the embodiment, the FEC headers are used to indicate whether FEC header in the next FEC frames are in the same PLP as the current FEC frame and whether the two FEC frames have the same FEC frame header.

For example, if there are two headers before one QAM modulated LDPC packet, and PLP identifier, modulation and coding parameters are same in these headers, it will be known in this PLP, the next QAM modulated LDPC packets will have same modulation and coding parameters as that of the current QAM modulated LDPC packet, even if the next LDPC packets do not have the frame header. This conclusion can be kept until two consecutive FEC frames include different headers.

In FEC frame builder 107, two headers are arranged before one QAM modulated LDPC packet, so a comparison between two FEC headers is needed. When PLP identifiers are same, but modulation and coding parameters are not the same in the two headers, we can know in this PLP, the next QAM modulated LDPC packet will have different modulation and coding parameters from that of the current QAM modulated LDPC packet. And the next signalling information including different modulation and coding parameters of the next QAM modulated LDPC packet in this PLP is built and shown in the second header.

Using the embodiment of the invention, the multiple consecutive FEC frames following two same headers must have the same PLP number and modulation and coding parameters.

Although, the repetition of FEC header will possibly lead very little overhead increase in some case, but overhead is reduce significantly for the broadcast modes as the number of actually transmitted headers is reduced drastically because of the deletion of the same FEC headers.

Returning now to Figure 3, the FEC frame is interleaved in OFDM frame builder 108. In addition, the encoded C2 frames then are transmitted to receiver 200 through communication channel.

Receiver 200 comprises a FEC frame detector 201, a de-mapping device 202 and FEC decoder 204. Alternatively, like transmitter 100, receiver 200 is also a processor-based system and includes one or more processors and associated memory. In this context, computer programs, or software, are stored in the memory for execution by the processor, e.g., to implement FEC decoder 204. The processor is representative of one or more stored-program control processors and these do not have to be dedicated to the signalling information process function, e.g., the processor may also control other functions of receiver 200. The memory is representative of any storage device, e.g., random-access memory (RAM), read-only memory (ROM), etc.; may be internal and/or external to receiver 200; and is volatile and/or non-volatile as necessary.

In receiver 200, the FEC frame detector 201 is adapted to obtain FEC frames from the received OFDM signals. The de-mapping device 202 is adapted to demodulate the FEC frame, and FEC decoder 204 is adapted to decode the FEC frame to recover the signalling information and data. In particular, for example, if there are two headers before one QAM modulated LDPC packet, and PLP identifier, modulation and coding parameters are the same in these headers, it will be known in this PLP, the next QAM modulated LDPC packets will have same modulation and coding parameters as that of the current QAM modulated LDPC packet. This conclusion can be kept until two different headers happen.

If there are two headers before one QAM modulated LDPC packet, and PLP identifier, modulation and coding parameters are different with each other, it will be known in this PLP, the next QAM modulated LDPC packets will have different modulation and coding parameters from that of the current QAM modulated LDPC packet, or the two FEC frames are in different PLP.

In the embodiment, a specific arrangement of the FEC frame is described to implement repetition FEC headers for a FEC frame. However, other repetition FEC frame header can also be used.

The foregoing merely illustrates the embodiment of the invention and it will thus be appreciated that those skilled in the art will be able to devise numerous alternative arrangements which, although not explicitly described herein, embody the principles of the invention and are within its scope.

## Claims

1. A method used in a transmitter of a communication system, comprising:
building a first Forward Error Correction, FEC, frame comprising at least two FEC frame headers and a data packet, wherein one of the at least two FEC frame headers is a signalling information of the first FEC frame and other of the at least two FEC frame headers is respectively a signalling information of at least one consecutive second FEC frame after the first FEC frame; and
building the at least one consecutive second FEC frame comprising the data packet of the at least one consecutive second FEC frame and omitting its FEC headers if the at least two FEC frame headers are the same.

2. The method according to claim 1, wherein if the at least two FEC frame headers are different from each other, the method comprises building the consecutive second FEC frame comprising at least two FEC frame headers and a data packet, wherein one of the at least two FEC frame headers is a signalling information of the consecutive second FEC frame and other of the at least two FEC frame headers is respectively a signalling information of at least one consecutive third FEC frame after the consecutive second FEC frame; and building the at least one consecutive third FEC frame comprising the data packet of the at least one consecutive third FEC frame and omitting its FEC headers if the at least two FEC frame headers are the same.

3. The method according to claim 1 or 2, wherein the signaling information includes information representative of a Physical Layer Pipe, a modulation and a code rate.

4. A transmitter (100) of a communication system, comprising:
a FEC frame builder (107) for building a first Forward Error Correction, FEC, frame by at least two FEC frame headers and a data packet, wherein one of the at least two FEC frame headers is a signalling information of the first FEC frame and other of the at least two FEC frame headers is respectively a signaling information of at least one consecutive second FEC frame after the first FEC frame; and for building the at least one consecutive second FEC frame comprising the data packet of the at least one consecutive second FEC frame and omitting its FEC headers if the at least two FEC frame headers are the same.

5. The transmitter according to claim 4, wherein if the at least two FEC frame headers are different from each other, the builder is adapted to build the consecutive second FEC frame to comprise at least two FEC frame headers and a data packet, wherein one of the at least two FEC frame headers is a signalling information of the consecutive second FEC frame and other of the at least two FEC frame headers is respectively a signalling information of at least one consecutive third FEC frame after the consecutive second FEC frame; and building the at least one consecutive third FEC frame comprising the data packet of the at least one consecutive third FEC frame and omitting its FEC headers if the at least two FEC frame headers are the same.

6. A method used in a receiver (200) of a communication system, for decoding an encoded frame, comprising:
receiving a first FEC frame including at least two FEC frame headers and data packet, wherein one of the at least two FEC frame headers is a signalling information of the first FEC frame and other of the at least two FEC frame headers is respectively a signalling information of at least one consecutive second FEC frame after the first FEC frame;
comparing the at least two FEC frame headers, and if the at least two FEC frame headers are the same, the at least one consecutive second FEC frame only includes the data packet thereof without a FEC frame header.

7. The method according to claim 6, wherein the signaling information includes information representative of a Physical Layer Pipe, a modulation and a code rate.

8. A receiver (200) for implementing the method for decoding an encoded frame according to any one of claims 6-7.

## Patentansprüche

1. Verfahren, das in einem Sender eines Kommunikationssystems verwendet wird, wobei das Verfahren Folgendes umfasst:
Aufbauen eines ersten Vorwärtsfehlerkorrekturrahmens, FEC-Rahmens, der mindestens zwei FEC-Rahmen-Anfangsblöcke und ein Datenpaket umfasst, wobei einer der mindestens zwei FEC-Rahmen-Anfangsblöcke Signalisierungsinformationen des ersten FEC-Rahmens sind und der andere der mindestens zwei FEC-Rahmen-Anfangsblöcke jeweils Signalisierungsinformationen mindestens eines aufeinanderfolgenden zweiten FEC-Rahmens nach dem ersten FEC-Rahmen sind; und
Aufbauen des mindestens einen aufeinanderfolgenden zweiten FEC-Rahmens, der das Datenpaket des mindestens einen aufeinanderfolgenden zweiten FEC-Rahmens umfasst, und Weglassen seiner FEC-Anfangsblöcke, falls die mindestens zwei FEC-Rahmen-Anfangsblöcke dieselben sind.

2. Verfahren nach Anspruch 1, bei dem das Verfahren das Aufbauen des aufeinanderfolgenden zweiten FEC-Rahmens, der mindestens zwei FEC-Rahmen-Anfangsblöcke und ein Datenpaket umfasst, umfasst, wobei einer der mindestens zwei FEC-Rahmen-Anfangsblöcke Signalisierungsinformationen des aufeinanderfolgenden zweiten FEC-Rahmens sind und der andere der mindestens zwei FEC-Rahmen-Anfangsblöcke jeweils Signalisierungsinformationen mindestens eines aufeinanderfolgenden dritten FEC-Rahmens nach dem aufeinanderfolgenden zweiten FEC-Rahmen sind, falls die mindestens zwei FEC-Rahmen-Anfangsblöcke voneinander verschieden sind; und Aufbauen des mindestens einen aufeinanderfolgenden dritten FEC-Rahmens, der das Datenpaket des mindestens einen aufeinanderfolgenden dritten FEC-Rahmens umfasst, und Weglassen seiner FEC-Anfangsblöcke, falls die mindestens zwei FEC-Rahmen-Anfangsblöcke dieselben sind.

3. Verfahren nach Anspruch 1 oder 2, bei dem die Signalisierungsinformationen Informationen enthalten, die eine Pipe der Bitübertragungsschicht, eine Modulation und eine Coderate repräsentieren.

4. Sender (100) eines Kommunikationssystems, wobei der Sender umfasst:
eine FEC-Rahmen-Aufbaueinrichtung (107) zum Aufbauen eines ersten Vorwärtsfehlerkorrekturrahmens, FEC-Rahmens, durch mindestens zwei FEC-Rahmen-Anfangsblöcke und durch ein Datenpaket, wobei einer der mindestens zwei FEC-Rahmen-Anfangsblöcke Signalisierungsinformationen des ersten FEC-Rahmens sind und der andere der mindestens zwei FEC-Rahmen-Anfangsblöcke jeweils Signalisierungsinformationen mindestens eines aufeinanderfolgenden zweiten FEC-Rahmens nach dem ersten FEC-Rahmen sind; und zum Aufbauen des mindestens einen aufeinanderfolgenden zweiten FEC-Rahmens, der das Datenpaket des mindestens einen aufeinanderfolgenden zweiten FEC-Rahmens umfasst, und Weglassen seiner FEC-Anfangsblöcke, falls die mindestens zwei FEC-Rahmen-Anfangsblöcke dieselben sind.

5. Sender nach Anspruch 4, bei dem die Aufbaueinrichtung dafür ausgelegt ist, den aufeinanderfolgenden zweiten FEC-Rahmen in der Weise aufzubauen, dass er mindestens zwei FEC-Rahmen-Anfangsblöcke und ein Datenpaket umfasst, wobei einer der mindestens zwei FEC-Rahmen-Anfangsblöcke Signalisierungsinformationen des aufeinanderfolgenden zweiten FEC-Rahmens sind und der andere der mindestens zwei FEC-Rahmen-Anfangsblöcke jeweils Signalisierungsinformationen mindestens eines aufeinanderfolgenden dritten FEC-Rahmens nach dem aufeinanderfolgenden zweiten FEC-Rahmen sind, falls sich die mindestens zwei FEC-Rahmen-Anfangsblöcke voneinander unterscheiden; und Aufbauen des mindestens einen aufeinanderfolgenden dritten FEC-Rahmens, der das Datenpaket des mindestens einen aufeinanderfolgenden dritten FEC-Rahmens umfasst, und Weglassen seiner FEC-Anfangsblöcke, falls die mindestens zwei FEC-Rahmen-Anfangsblöcke dieselben sind.

6. Verfahren, das in einem Empfänger (200) eines Kommunikationssystems verwendet wird, um einen codierten Rahmen zu decodieren, wobei das Verfahren Folgendes umfasst:
Empfangen eines ersten FEC-Rahmens, der mindestens zwei FEC-Rahmen-Anfangsblöcke und ein Datenpaket enthält, wobei einer der mindestens zwei FEC-Rahmen-Anfangsblöcke Signalisierungsinformationen des ersten FEC-Rahmens sind und der andere der mindestens zwei FEC-Rahmen-Anfangsblöcke jeweils Signalisierungsinformationen mindestens eines aufeinanderfolgenden zweiten FEC-Rahmens nach dem ersten FEC-Rahmen sind;
Vergleichen der mindestens zwei FEC-Rahmen-Anfangsblöcke, wobei der mindestens eine aufeinanderfolgende zweite FEC-Rahmen nur das Datenpaket davon ohne einen FEC-Rahmen-Anfangsblock enthält, falls die mindestens zwei FEC-Rahmen-Anfangsblöcke dieselben sind.

7. Verfahren nach Anspruch 6, bei dem die Signalisierungsinformationen Informationen enthalten, die eine Pipe einer Bitübertragungsschicht, eine Modulation und eine Coderate repräsentieren.

8. Empfänger (200) zum Implementieren des Verfahrens zum Decodieren eines codierten Rahmens nach einem der Ansprüche 6-7.

## Revendications

1. Procédé utilisé dans le transmetteur d'un système de communication, comprenant : la mise en place d'une première trame de correction d'erreurs sans voie de retour (FEC), trame comprenant au moins deux en-têtes de trame FEC et un paquet de données, dans lequel un des deux en-têtes au moins de trame FEC est une information de signalisation de la première trame FEC et un autre des deux en-têtes au moins de trame FEC est respectivement une information de signalisation d'au moins une deuxième trame consécutive FEC après la première trame FEC, et la mise en place de la seconde trame FEC consécutive au moins comprenant le paquet de données de la seconde trame consécutive FEC au moins et omettant ses en-têtes FEC si les deux en-têtes au moins de trame FEC sont les mêmes.

2. Procédé selon la revendication 1, dans lequel les deux en-têtes de trame FEC au moins sont différents l'un de l'autre, le procédé comprenant la mise en place de la seconde trame FEC consécutive comprenant au moins deux en-têtes de trame FEC et un paquet de données, dans lequel un des deux en-têtes au moins de trame FEC consécutive est une information de signalisation de la seconde trame FEC consécutive et l'autre des deux en-têtes au moins de trame FEC est respectivement une information de signalisation d'au moins une troisième trame consécutive FEC après la seconde trame FEC consécutive, et la mise en place d'une troisième trame FEC consécutive au moins comprenant le paquet de données de la troisième trame consécutive FEC au moins et omettant ses en-têtes FEC si les deux en-têtes de trame FEC au moins sont les mêmes.

3. Procédé selon les revendications 1 ou 2, dans lequel les informations de signalisation comprennent des informations représentatives d'un tuyau de couche physique (PLP), d'une modulation et d'un taux de code.

4. Transmetteur (100) d'un système de communication comprenant : un constructeur de trame FEC (107) pour la mise en place d'une première trame de correction d'erreurs sans voie de retour (FEC), trame avec au moins deux en-têtes de trame FEC et un paquet de données, dans lequel un des deux en-têtes au moins de trame FEC est une information de signalisation de la première trame FEC et l'autre des deux en-têtes au moins de trame FEC est respectivement une information de signalisation d'une deuxième trame consécutive FEC au moins après la première trame FEC, et pour la mise en place de la seconde trame FEC consécutive au moins comprenant le paquet de données de la seconde trame consécutive FEC au moins et omettant ses en-têtes FEC si les deux en-têtes au moins de trame FEC sont les mêmes.

5. Transmetteur selon la revendication 4, dans lequel si les deux en-têtes au moins de trame FEC sont différents l'un de l'autre, l'élaborateur est adapté à la mise en place de la seconde trame FEC consécutive de façon à ce qu'elle comprenne au moins deux en-têtes de trame FEC et un paquet de données, dans lequel un des deux en-têtes au moins de trame FEC est une information de signalisation de la seconde trame FEC consécutive et l'autre des deux en-têtes au moins de trame FEC, est respectivement une information de signalisation d'au moins une troisième trame FEC consécutive après la seconde trame FEC consécutive, et la mise en place d'une troisième trame FEC consécutive au moins comprenant le paquet de données de la troisième trame consécutive FEC au moins et omettant ses en-têtes FEC si les deux en-têtes au moins de trame FEC sont les mêmes.

6. Procédé utilisé dans un récepteur (200) d'un système de communication pour le décodage d'une trame codée, comprenant :
la réception d'une première trame FEC comprenant au moins deux en-têtes de trame FEC et un paquet de données, dans lequel un des deux en-têtes au moins de trame FEC est une information de signalisation de la première trame FEC et l'autre des deux en-tête au moins de trame FEC est respectivement une information de signalisation d'au moins une seconde trame FEC consécutive après la première trame FEC ; comparant les deux en-têtes au moins de trame FEC, et si les deux en-têtes au moins de trame FEC sont les mêmes, la seconde trame FEC consécutive au moins ne comprend que le paquet de données qui en résulte, sans en-tête de trame FEC.

7. Procédé selon la revendications 6, dans lequel les informations de signalisation comprennent des informations représentatives d'un tuyau de couche physique (PLP), d'une modulation et d'un taux de code.

8. Récepteur (200) pour implémenter le procédé de décodage d'une trame codée selon l'une quelconque des revendications 6 à 7.
